# EUROPEAN PATENT SPECIFICATION

(11) **EP 4 357 980 B1**
(45) Date of publication and mention of the grant of the patent: **02.12.2026**
(21) Application number: 22306600.2
(22) Date of filing: 21.10.2022
(51) Int. Cl.: G11C 13/00, G11C 11/54, G06N 3/065, G06N 3/049

(54) **NEURAL NETWORK CIRCUIT WITH DELAY LINE**
NEURONALE NETZWERKSCHALTUNG MIT VERZÖGERUNGSLEITUNG
CIRCUIT DE RÉSEAU NEURONAL AVEC LIGNE À RETARD

(43) Date of publication of application: 24.04.2024
(73) Proprietor: Commissariat à l'Energie Atomique et aux Energies Alternatives, 75015 Paris (FR); Universität Zürich, 8006 Zürich (CH)
(72) Inventor: MORO, Filippo, 38054 Grenoble Cedex 09 (FR); VIANELLO, Elisa, 38054 Grenoble Cedex 09 (FR); INDIVERI, Giacomo, 8057 Zürich (CH); PAYVAND, Melika, 8057 Zürich (CH)
(74) Representative: Cabinet Beaumont

(56) References cited:
- PEDRETTI G. ET AL: "Memristive neural network for on-line learning and tracking with brain-inspired spike timing dependent plasticity", vol. 7, no. 1, 13 July 2017 (2017-07-13), pages 1 - 10, XP093024114, Retrieved from the Internet <URL:https://link.springer.com/content/pdf/10.1038/s41598-017-05480-0.pdf> DOI: 10.1038/s41598-017-05480-0
- MORO FILIPPO ET AL: "Neuromorphic object localization using resistive memories and ultrasonic transducers", vol. 13, no. 1, 18 June 2022 (2022-06-18), XP093024015, Retrieved from the Internet <URL:https://www.nature.com/articles/s41467-022-31157-y> DOI: 10.1038/s41467-022-31157-y
- SUN JUNWEI ET AL: "Memristor-Based Neural Network Circuit of Full-Function Pavlov Associative Memory With Time Delay and Variable Learning Rate", IEEE TRANSACTIONS ON CYBERNETICS, IEEE, PISCATAWAY, NJ, USA, vol. 50, no. 7, 1 July 2020 (2020-07-01), pages 2935 - 2945, XP011793725, ISSN: 2168-2267, [retrieved on 20200616], DOI: 10.1109/TCYB.2019.2951520

## Description

### Technical field

The present disclosure relates generally to a circuit implementing a neural network and more particularly to a neural network circuit implemented using Resistive Random-Access Memory (RRAM).

### Background art

Neuromorphic circuits have been proposed that reproduce the main characteristics of a biological neuron. Such circuits are configured to integrate signals, coming from other neuromorphic circuits, over time.

In a biological neuron, an important part of the sensory information is expressed by the timing of spikes coming from other biological neurons and sensory pathways. The signals are decoded by the synapses of the neuron by, inter alia, detecting the coincidence between the arriving spikes.

There is a need in the art for an artificial neural network capable of taking into consideration spike arrival times, while remaining relatively low-cost in terms of chip area and/or of low complexity.
The publication by Pedretti et al. "Memristive neural network for on-line learning and tracking with brain-inspired spike timing dependent plasticity" describes unsupervised learning and tracking in a spiking neural network with memristive synapses, where synaptic weights are updated via brain-inspired spike timing dependent plasticity.

### Summary of Invention

The invention is defined by the appended set of claims. The object of the invention is solved by the features of the independent claims. Further embodiments are the subject-matter of the dependent claims.

### Brief description of drawings

The foregoing features and advantages, as well as others, will be described in detail in the following description of specific embodiments given by way of illustration and not limitation with reference to the accompanying drawings, in which:
Figure 1 schematically illustrates a hardware implementation of a CMOS-based dendritic architecture circuit according to an embodiment of the present disclosure;
Figure 2 schematically illustrates a hardware implementation of the synapse circuit according to an embodiment of the present disclosure;
Figure 3 is a temporal diagram showing certain signals present in the synapse circuit of Figure 2 according to an embodiment of the present disclosure;
Figure 4 is a diagram of high resistive states of a resistive memory based on OxRAM devices;
Figure 5 schematically illustrates a hardware implementation of a dendritic circuit according to an embodiment of the present disclosure;
Figure 6 schematically illustrates a hardware implementation of a sub-circuit of a neural network according to another embodiment of the present disclosure;
Figure 7 illustrates an example of a Ferro-Tunnel Junction element and its equivalent circuit;
Figure 8A illustrates eight families of measurements of an FTJ device;
Figure 8B is a diagram representing current in Ferro-Tunnel Junction devices under various voltage conditions;
Figure 9 schematically illustrates a hardware implementation of the synapse circuit according to an embodiment of the present disclosure;
Figure 10 schematically illustrates a hardware implementation of the fall-edge detector according to an embodiment of the present disclosure;
Figure 11 schematically illustrates an example of a hardware implementation of an unbalanced inverter; and
Figure 12 is temporal diagram illustrating time delays implemented by a synapse circuit according to an embodiment of the present disclosure.

### Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail. For example, circuits and methods for programming the resistance of a resistive memory element have not been described in detail, the selection of suitable circuits and methods depending on the particular type of resistive memory element being within the capabilities of those skilled in the art.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the various embodiments, transistors are described as having main conducting nodes and a gate node, without limiting to any particular transistor technology. Those skilled in the art will understand that, in the case that the transistor are implemented by MOS transistors, the main conducting nodes are the source and drain. Unless specified otherwise, the MOS transistors are n-channel devices, although it will be apparent to those skilled in the art how the embodiments could be adapted for the case of p-channel MOS transistors. It would equally be possible for other transistor technologies to be used. For example, in the case of bipolar transistors, the main conducting nodes are the collector and emitter, and the gate is implemented by the base.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures.

Unless specified otherwise, the expressions "around", "approximately", "substantially" and "in the order of" signify within 10 %, and preferably within 5 %.

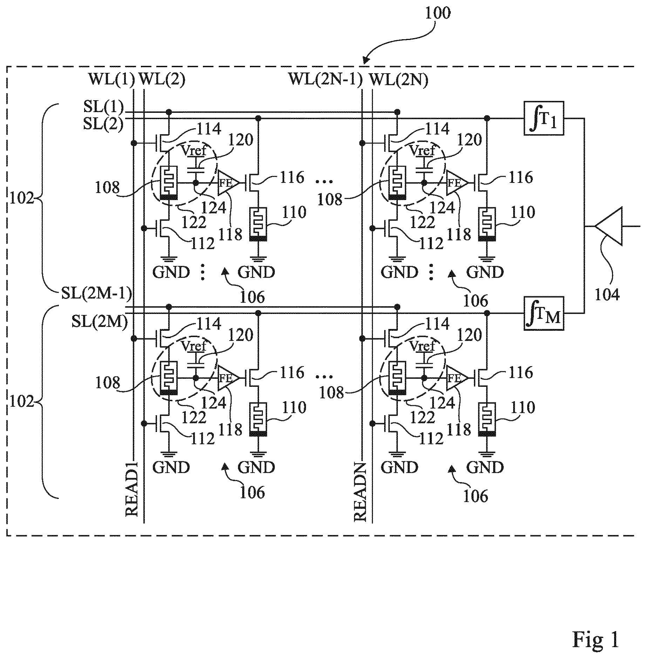

Figure 1 schematically illustrates a hardware implementation of a CMOS-based dendritic architecture circuit 100 according to an embodiment of the present disclosure.

The circuit 100 comprises a plurality M of dendritic circuits 102. Each dendritic circuit 102 comprises a plurality N of synapse circuits 106. Each synapse circuit 106 is configured to receive an input signal (READ1, READN) and to generate an output signal after a certain time delay based on an associated time delay parameter and on an associated weight. Furthermore, each dendritic circuit 102 for example comprises a further synapse circuit associated with an integration function that applies a corresponding integration time constant (*T*₁, *T_{M}*). In each dendritic circuit 102, the outputs of the synapse circuits 106 are for example coupled to an input of the corresponding further synapse circuit *T*₁ to *T_{M}* of the dendritic circuit 102, the further synapse circuit providing an integrated output signal of the dendritic circuit 102. The integrated output signals from each dendritic circuit 102 are for example summed and provided to a neuron 104, which generates an output spike when a threshold is reached.

The time delay and weight parameters of each synapse circuit 106 are to be learned, such that when a certain temporal feature is present in the input signal of the dendritic circuit 102, the delayed spikes from each synapse circuit 106 of the dendritic circuit 102 are aligned). Depending on the threshold applied by the neuron 104, such an alignment of the spikes in one or more of the dendritic circuits 102 causes the neuron 104 to elicit a spike, which means that a coincidence has been detected.

The dendritic circuits 102 are for example arranged in rows, and the plurality of synapse circuits 106 of each dendritic circuit 102 are arranged in columns, such that the dendritic circuits 102 forms an array. All the synapses circuits 106 in a same column for example share the same input signal READ1 to READN provided on odd word-lines WL(1) to WL(2N-1) respectively, and are activated by a same activation signal provided on corresponding even word-lines WL(2) to WL(2N).

Each synapse circuit 106 comprises a resistor-capacitor circuit 122 (RC circuit) comprising a programmable resistive element 108 coupled to a capacitance 120, which is for example a parasitic capacitance, although in alternative embodiments it could be implemented by a dedicated capacitor. The RC circuit 122 is configured to implement the time delay associated with the synapse circuit 106.

Each of the programmable resistive element 108 is for example an element based on a metal-insulator-metal (MIM) structure, such as an OxRAM element, where the insulator is for example an oxide, for example comprising HfO₂, Ta₂O₅, or SiO₂. Alternatively, each of the programmable resistive element 108 is for example a Ferroelectric tunneling junction (FTJ) device, as described in more detail in the publication "Low-power linear computation using nonlinear ferroelectric tunnel junction memristors." published in Nat Electron 3, 259-266 (2020) by Berdan, R., Marukame, T., Ota, K. et al. An advantage of FTJ devices is that they are capable of being programmed to have relatively high resistances up to 1 Giga-ohm or more, allowing relatively high time delays to be introduced.

Each synapse circuit 106 further comprises a programmable resistive element 110 storing a synaptic weight of the synapse circuit 106.

Each of the programmable resistive element 110 is for example an element based on a metal-insulator-metal (MIM) structure, such as an OxRAM element, where the insulator is for example an oxide, for example comprising HfO₂, Ta₂O₅, or SiO₂. In the case that the elements 108 are implemented by FTJ devices, an advantage of using OxRAM element for the element 110 is that OxRAM can be co-integrated with FTJ devices.

Each synapse circuit 106 for example further comprises a transistor 112 and a transistor 114. The resistive element 108 for example has one of its nodes coupled to the ground (GND) rail via the main conducting nodes of the transistor 112, and its other node coupled to a corresponding source line SL(1) via the main conducting nodes of the transistor 114. The transistor 112 for example has its gate coupled to a corresponding word line WL(2). The transistor 114 for example has its gate coupled to an associated word line WL(1).

The resistive element 110 for example has one of its nodes coupled to the ground rail, and its other node coupled, via the main conducting nodes of a transistor 116, to a corresponding source line SL(2).

Each synapse circuit 106 further comprises a comparator circuit 118 (FE) having its input coupled to an output node 124 of the RC circuit 122 and its output coupled to the gate of the transistor 116. Moreover, the capacitor 120 is for example coupled between the supply voltage rail *V_{ref}* and the node 124.

For example, the circuit 100 comprises a number *M* of dendritic circuits 102, each comprising a number *N* of synapses circuits 106, the synapse circuits 106 of the circuit 100 being arranged in an array of *M* rows and *N* columns. The transistors 114 and 116 of the synapse circuits 106 of the *i^{th}* row, *i* ∈ {1, ... , *M*} are respectively coupled to a same source line *SL*(2*i* - 1) and *SL*(2*i*)*.* Similarly, the transistors 112 and 114 of synapse circuits 106 of the *j^{th}* column, *j* ∈ {1, ... , *N*} are respectively coupled to a same word line *WL*(2*j* - 1) and *WL*(2*j*)*.* In some embodiments, the number M of dendritic circuits 102 is equal to the number N of synapses circuits 106 in each dendritic circuit 102, while in other embodiments the numbers N and M are not equal.

For example, the resistive element 108 and the transistor 114 of each synapse circuit 106 form a 1T1R (one transistor, one resistor) cell of an RRAM memory array (not illustrated).

In operation, the circuit 100 is for example capable of performing inference operation such as event detection based on the input signalsREAD1 to READN, and also of being programmed during a training phase. In particular, during the training phase, feedback is for example used in order to iteratively update the synaptic weights, and in some cases the time delays, of the synapse circuits 106, in order to achieve a desired detection performance.

During the event detection, the circuit 100 is for example activated by applying a supply voltage to the source lines SL(1) and SL(2) and to the word lines WL(1) and WL(2). The signals READ1 to READN applied to the gates of the transistors 112 of each synapse circuit 106 corresponds to input signals of the circuit 100. When a corresponding one of the input signals READ1 to READN has a positive voltage pulse, the RC circuit 122 of the synapse circuit is configured to delay the pulse by a time delay, and the comparator circuit 118 of the synapse circuit 106 is configured to generate an output pulse after the time delay. This output pulse activates the corresponding transistor 116, and causes a synapse output current to be conducted by the resistive element 110. This synapse output current is then integrated by the corresponding integration function of the dendritic circuit 102 to which the synapse circuit 106 belongs. If the integration of this current causes an output signal of the integration function to exceed a threshold voltage of the neuron 104, the neuron 104 will generate an output voltage spike of the circuit 100.

An advantage of the circuit 100 is that it has been found to provide relatively high detection, while maintaining a relatively low memory footprint.

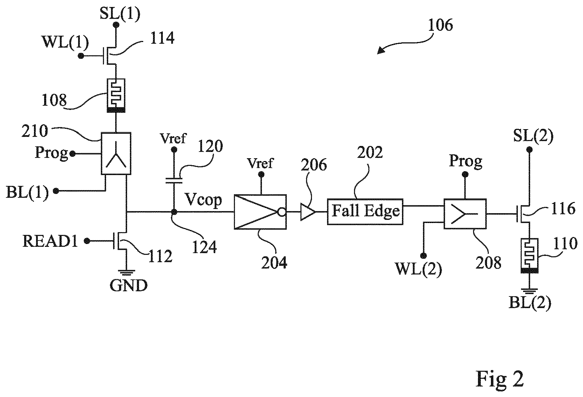

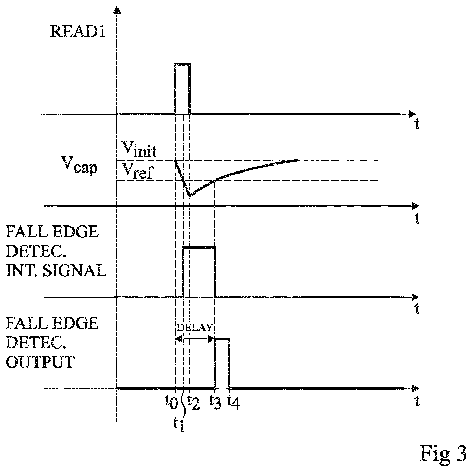

Operation of each synapse circuit 106 will now be described in more detail with reference to Figures 2 and 3.

Figure 2 schematically illustrates a hardware implementation of the top-left synapse circuit 106 of Figure 1 according to an embodiment of the present disclosure. The other synapse circuits 106 are for example implemented by similar circuits coupled to corresponding word-lines and source lines. The circuit 106 of Figure 2 comprises many of the same elements as those shown in Figure 1, and these elements are labelled with like reference numerals and will not be described again in detail.

In the example of Figure 2, the comparator circuit 118 of the synapse circuit 106 is implemented by a fall-edge detector (Fall Edge) 202, an unbalanced inverter 204 and an inverter 206.

The voltage at the output node 124 of the RC circuit 122 is named *V_{cap}* in Figure 2.

In the example of Figure 2, the synapse circuit 106 further comprises multiplexers 208 and 210 for permitting the programming of the programmable resistive elements 108 and 110. The multiplexer 208 example has one input coupled to the output of the fall edge detector 202, and its other input coupled to the even word-line WL(2). The output of the multiplexer 208 is coupled to the gate of the transistor 116. coupled to a bit line (BL(1)). The multiplexers 208 and 210 are for example each controlled by a programming signal Prog. The element 108 is for example programmed by asserting the signal Prog, and applying appropriate voltages to the lines BL(1), WL(1) and SL(1). The element 110 is for example programmed by asserting the signal Prog, and applying appropriate voltages to the lines BL(2), WL(2) and SL(2).

Figure 3 is a temporal diagram showing certain signals present in the synapse circuit 106 of Figure 2 according to an embodiment of the present disclosure. In particular, Figure 3 illustrates the signal READ1, the voltage *V_{cap},* an internal signal (FALL-EDGE DETEC. INT. SIGNAL) of the fall-edge detector 202 and the output signal (FALL-EDGE DETEC. OUTPUT) of the falling edge detector 202.

The input signal READ1, received by the synapse circuit 106, comprises a positive pulse that is high from a time *t*₀ until a time *t*₂. The positive pulse of input signal READ causes the activation of the transistor 112, and thus causes the voltage *V_{cap}* at the node 124 to be discharged to ground. In particular, at the time *t*₀, the voltage *V_{cap}* has an initial value *Vᵢₙᵢₜ,* which is for example a voltage level close to that of the supply voltage on the source line SL(1). Once the positive pulse of the input signal READ is received by the synapse circuit 106, the capacitor voltage *V_{cap}* begins to decrease, and continues to decrease until the end of the input signal READ at the time *t*₂.

At a time *t*₁ after *t*₀ but before *t*₂, the voltage *V_{cap}* crosses the value of a threshold voltage *Vₜₕ.* This causes the internal signal of the fall-edge detector 202 to rise.

At the time *t*₂, the positive pulse of the input signal READ ends, and the transistor 112 is deactivated. The voltage *V_{cap}* therefore starts to increase towards its initial value *Vᵢₙᵢₜ.*

At a time *t*₃, the voltage *V_{cap}* crosses again the threshold voltage *Vₜₕ,* causing the internal signal of the fall-edge detector 202 to fall low, and causes the output signal of the fall-edge detector 202 to rise. The output signal of the fall-edge detector 202 for example falls low again at a time *t*₄, after a fixed time delay.

The value of the threshold voltage *Vₜₕ* is for example adjustable, and allows the time delay between the positive pulse of the read signal and the positive pulse of the output signal to be controlled, in addition to varying the time constant of the RC circuit 122.

Thus, the interval between the times *t*₀ and *t*₃ depends on the delay parameter implemented by the RC circuit 122 and on the value of the threshold voltage *Vₜₕ.* This interval corresponds to a delay (DELAY) between the reception of the positive pulse of the input signal READ and the generation of the output signal by the fall-edge detector 202.

In some embodiments, the magnitude of the time delays introduced by the RC circuits 122 are chosen to be in the order of the time constant of the input signal. As an example, the circuit 100 can be used to detect anomalies in an ECG (Electrocardiogram), and for this application the time constant of the input signal is in the order of between 10 and 100 milliseconds. Producing such delays on chips is not area efficient, as it involves the use of large capacitors and/or resistors of high resistance. Therefore, implementing the RC delay circuit 122 exploiting resistive memory (RRAM), as described in relation with Figure 1, results in an area-efficient architecture.

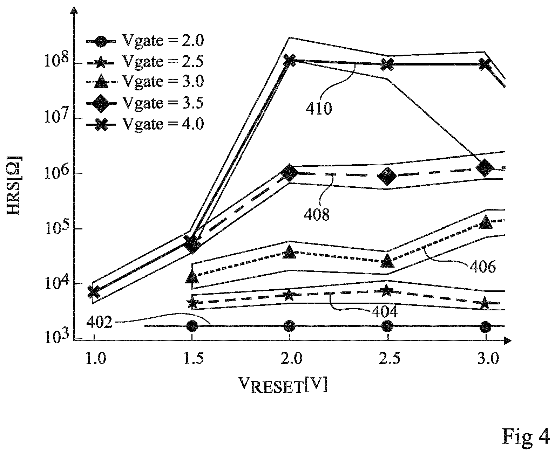

For example, to produce time delays, using the RC circuit 122, in the order of 100 milliseconds, the RRAM is operated in its High Resistive State (HRS). In some cases, the resistive elements 108 are programmed to be in their high resistive states and to have desired resistances that are determined and controlled during training. However, for some technologies of RRAM devices, the conductive filament resulting in resistive switching is very weak in the HRS, and thus controlling the resistance of RRAM in the HRS is difficult, as will now be explained with reference to Figure 4.

Figure 4 is a diagram of high resistive states of a resistive memory based on OxRAM devices. More particularly, Figure 4 shows HRS measurements as a function of a reset voltage (*V_{RESET}*[*V*]) applied in order to reset the OxRAM device to the HRS. In the synapse circuits 106 of Figure 1, the reset voltage is for example applied to the source line SL(1), and is applied to the resistive elements 108 by activating the corresponding transistors 114. As shown in Figure 4, curves 402, 404, 406, 408 and 410 respectively correspond to a voltage *V_{gate},* at the gate of transistor 114, of 2 V, 2.5 V, 3 V, 3.5 V and 4 V. Curves 402 to 410 show a large variability in the HRS, which follow a log normal distribution. The mean of this distribution is a function of the reset voltage that is applied in order to reset the resistive element 108 to the HRS.

Thus, the reset voltage can be used as a knob that sets the order of magnitude of the time delay in each synapse circuit 106. Due to variability, using the same reset voltage to reset the resistive element 108 of each synapse circuit 106 results in sampling from the corresponding same log-normal distribution associated with the reset voltage. In some embodiments, the resistance of the resistive element 108 of each synapse circuit 106 is selected in this manner, and is for example then kept constant during subsequent operation of the circuit. The resistances of the resistive elements 108 will thus correspond to varied levels centered around a mean resistance level. The network objective is then to learn the correct weights, applied by the resistive elements 110, corresponding to each time delay, such that the neuron circuit 100 performs effective coincidence detection in order to detect the feature of the input signal, for example of the input signal READ1.

Whereas the resistive elements 108 are programmed to be in their high resistive state, the elements 110 of each synapse circuit 106 are for example programmed to be in their low resistive state, which is advantageous as it permits a fine control of their resistances.

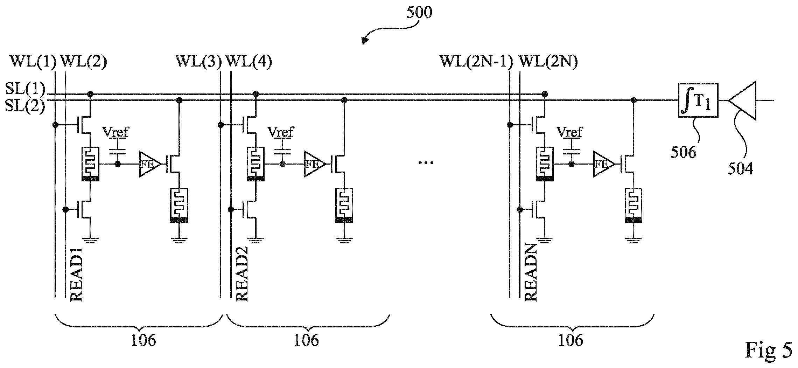

Figure 5 schematically illustrates a hardware implementation of a dendritic circuit 500 (DENDRITE) according to an embodiment of the present disclosure.

The dendritic circuit 500 comprises a plurality of synapses circuits 106 coupled in series to the source lines SL(1) and SL(2). Each synapse circuit 106 is for example as described in relation with Figures 1 and 2, and supplies on the source line SL(2) an output signal depending on the associated delay parameter and weight, determined by the resistive elements 108 and 110. Moreover, each synapse circuit 106 of the dendritic circuit 500 receives a corresponding input signal READ1, READ2 to READN, from example transmitted by another neuron circuit of the network (not illustrated in Figure 5).

The common source line SL(2) is coupled to the input of a neuron circuit 504 via a further synapse circuit 506, which is for example configured to integrate the current on the source line SL(2) by applying a corresponding integration time constant *T*₁. The neuron circuit 504 for example is a leaky integrate-and-fire (LIF) neuron circuit.

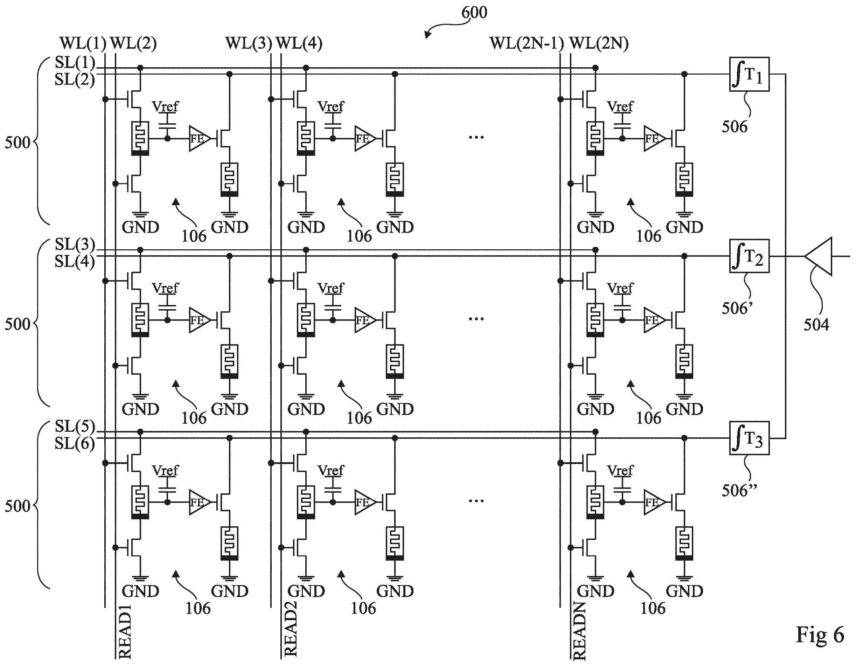

Figure 6 schematically illustrates a hardware implementation of a sub-circuit 600 of a neural network according to another embodiment of the present disclosure.

The sub-circuit 600 comprises a plurality (three according to the example of Figure 6) of the dendritic circuits 500 of Figure 5, each having common source-lines SL(2i-1) and SL(2i), where for example *i* ∈ {1,2,3}, coupled by the even source-line (SL(2), SL(4) and SL(6)) to the corresponding neuron circuit 504. More particularly, each dendritic circuit 500 is coupled to the neuron circuit 504 via a corresponding further synapse circuit 506, 506' and 506'' applying a corresponding integration time constant *T*₁, *T*₂ and *T*₃. Each dendritic circuit 500 of the circuit 600 for example receives input signals READ1 to READN from an input of the neural network or from another neuron circuit of the neural network. As the time constants associated with each dendritic circuit 500 depends on the delay and weight parameters of each of its synapse circuits 106, the presence of the output spike of the associated neuron circuit 504 depends on these time constants. The output neuron circuit 504 is for example a LIF neuron circuit configured to output a signal based on a coincidence detection between the output spikes generated by the synapse circuits 506, 506' and 506".

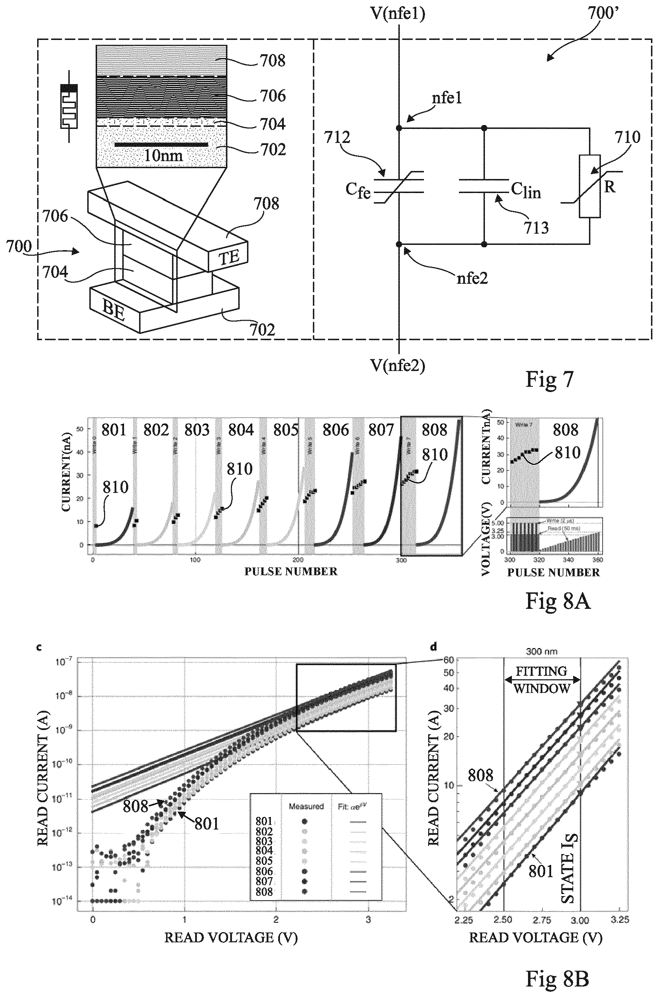

Figure 7 illustrates an example of a Ferro-Tunnel Junction (FTJ) element 700 and its equivalent circuit 700'.

The FTJ element 700 is for example used to implement the resistive elements 108 and/or 110 in the synapse circuits 106 of Figures 1, 2, 5 and 6. An advantage of the use of the FTJ element 700 as the resistive element 108 is that parasitic capacitances of this device, described in more detail below, can for example enable the capacitance of the capacitor 120 to be reduced or even for the capacitor 120 to be removed entirely.

The FTJ element 700 is for example formed of a stack of layers comprising a bottom electrode 702 (BE), a Silicon dioxide layer 704 (SiO₂) formed in the bottom electrode 702, a Hafnium Silicon Oxide layer 706 (HfSiO) or a Zirconium oxide (CMOS compatible) layer, for example, formed on the Silicon dioxide layer 704, and a top electrode 708 (TE) formed on the Hafnium Silicon Oxide layer 706.

As represented by the equivalent circuit 700', the FTJ element 700 can be considered to have a leakage resistor 710 of non-linear resistance *R*, in parallel with a Ferro-capacitor 712 of capacitance *C_{fe},* the resistor 710 and Ferro-capacitor 712 being in parallel with a linear capacitor 713 of capacitance *Cₗᵢₙ*. Furthermore, the capacitance *C_{fe}* of the Ferro-capacitor 712 is for example non-linear as a function of the voltage V across the device.

The current *I_{D}* that flows through an FTJ element is a tunneling current, which is not linear as a function of the voltage applied. This current is also relatively small compared to the one that flows through most other types of resistive memory devices. In such a ferroelectric element, by adjusting the ferroelectric polarization, a direct tunneling current, or a Fowler Nordheim assisted tunneling, can occur. This physical property allows the creation of multiple resistive states in FTJ elements.

The current *I_{D}* that flows in an FTJ element is described by the equation: [Math. 1] ${I}_{D} = {I}_{R} + {I}_{C} ,$ where [Math. 2] ${I}_{R} = {K}_{0} S \left(exp\left(V/\left({V}_{PO}-Δ{V}_{P}P/{P}_{sat}\right)\right)-1\right)$ and [Math. 3] ${I}_{C} = C \frac{dV}{dt}$ where *K*₀ is a fitting constant, *S* is the total surface of the device, V is the applied voltage between the bottom and top electrodes, and *V_{PO}* and Δ*V_{P}* are fitting constants. Since the value P is the polarization that can switch essentially between polarizations +Pr and -Pr, depending on the actual polarization, the voltage V will switch between voltage values VPO + Δ*V*_{P} and VPO - Δ*V*_{P}.

Figures 8A and 8B are diagrams representing current in Ferro-Tunnel Junction devices under various voltage conditions.

More particularly, Figure 8A illustrates eight families 801 to 808 of measurements of an 300x300nm FTJ device undergoing respectively 1 to 8 writing pulses (PULSE NUMBER) 810 emitted in periods Write0 to Write7. The measurement 808 is illustrated in more detail in the right part of Figure 8A.

Figure 8B illustrates the read current (READ CURRENT (A)) conducted by the FTJ device as a function of the read voltage (READ VOLTAGE (V)) in the range 0 and 3.25 V for each of the measurements 801 to 808. The curves 801 to 808 are fitted with $I = α {e}^{\ betaV}$ on a 2.5-3.0 V windows (FITTING WINDOW) . The resistance in the HRS of the FTJ device depends on the read voltage. For example, considering a read voltage of 2 V, the resulting current is in the order of 1 nA, and thus the resistance is around 1Gohm.

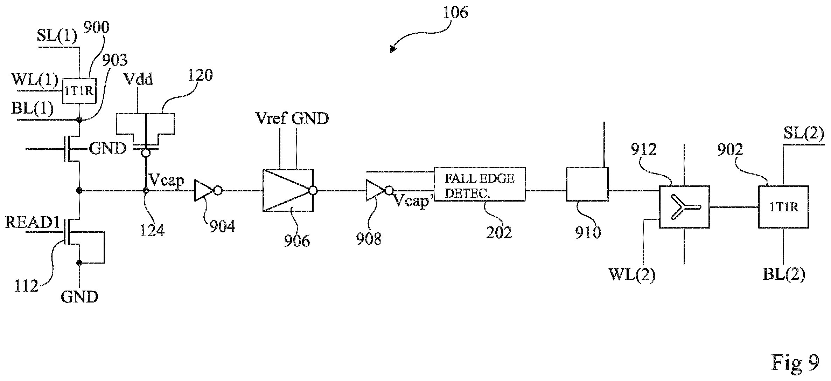

Figure 9 schematically illustrates a hardware implementation of a synapse circuit 106 according to an embodiment of the present disclosure.

The circuit 106 of Figure 9 comprises many of the same elements as those shown in Figures 1 and 2. However, in Figure 9, the synapse circuit 106 comprises a one transistor one resistor element 900 (1T1R) implementing the transistor 114 with the resistive element 108, and another 1T1R element 902 implementing the transistor 116 with the resistive element 110. An output node 903 of the 1T1R element 900 is for example coupled to a bit line BL(1) and the 1T1R element 902 is for example coupled to a bit line BL(2).

The capacitor 120 is for example implemented by the gate stack of a PMOS transistor having its two main conductive nodes and its bulk contact coupled together and to the supply voltage rail *V_{ref}.*

The output node 124 of the RC circuit 122 is for example coupled to the fall-edge detector 202 via the series connection of three inverters 904, 906 and 908. In some embodiments, the inverter 904 is an unbalanced inverter having a low threshold.

The fall-edge detector 202 is for example coupled to the 1T1R element 902 via a voltage adapter 910 and a multiplexer 912. The voltage adapter 910 is for example configured to increase the voltage level at the output of the fall-edge detector 202 to a level that is suitable for driving the 1T1R cell 902. The multiplexer 912 is for example configured to couple the output of the voltage adapter 910 to the input of the 1T1R cell 902 during an inference operation and/or during a training phase of the circuit, and to couple a word line WL(2) to the input of the 1T1R cell 902 during a programming operation of the 1T1R cell 902.

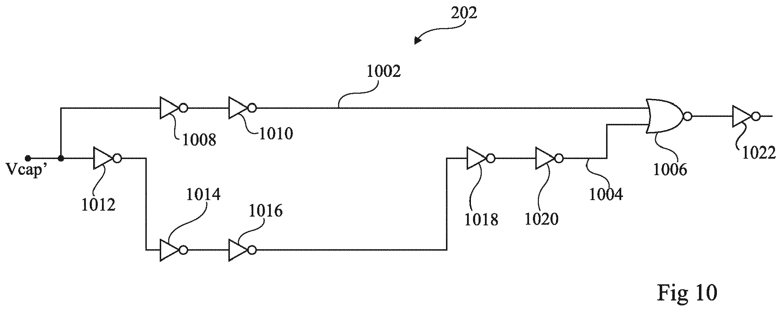

Figure 10 schematically illustrates a hardware implementation of the fall-edge detector 202 according to an embodiment of the present disclosure.

The fall-edge detector 202 for example comprises a first path coupling the input the fall-edge detector 202 to a first input 1002 of a NOR logic gate 1006, the first path for example comprising the series connection of two inverters 1008 and 1010. The fall-edge detector 202 also for example comprises a second path coupling the input the fall-edge detector 202 to a second input 1004 of the NOR logic gate 1006, the second path for example comprising the series connection of five inverters 1012, 1014, 1016, 1018 and 1020. In some embodiments, one or more of the inverters 1012 to 1020, for example the inverter 1014, is a starved inverter that receives a control voltage permitting a time delay introduced by the second path to be adjusted.

The output of the NOR gate 1006 is for example coupled to the output of the fall-edge detector 202 via an inverter 1022.

In operation, in the example of Figures 9 and 10, the fall-edge detector 202 for example receives a signal *V_{cap}',* which is a binary signal generated by the inverters 904, 906 and 908 of Figure 9. The voltage *V_{cap}* is for example initially at a high voltage close to the level of the supply voltage *V_{ref},* and thus the signal *V_{cap}'* is for example initially at a low level. Thus, the input 1002 of the NOR gate 1006 is for example low, and the input 1004 of the NOR gate 1006 is high, leading to a high output of the fall-edge detector 202. In this example, the transistor of the 1T1R cell 902 is a PMOS transistor.

Upon reception of a positive pulse of the signal READ, the voltage *V_{cap}* decreases, for example to a voltage value close to 0 V, and thus the signal *V_{cap}'* for example goes high, causing the input 1002 of the NOR logic gate 1006 to also go high. This does not change the output signal of the fall-edge detector 202, which for example remains high. Furthermore, after a time delay introduced by the second path, the input 1004 to the NOR gate 1006 will go low, which will also not change the output signal of the fall-edge detector 202.

The voltage *V_{cap}* will then rise due to the conduction of the 1T1R cell 900, and when the voltage *V_{cap}* exceeds the threshold of the inverter 904, the signal *V_{cap}'* will fall low. This will cause the input 1002 of the NOR logic gate 1006 to fall low, thereby bringing high the output of the NOR logic gate 1006, and bringing low the output of the fall-edge detector 202, thereby applying the start of an output pulse to the 1T1R cell 902. Furthermore, after a time delay introduced by the second path, the input 1004 to the NOR logic gate 1006 will go high, which will cause the output of the NOR gate 1006 to fall low, and the output signal of the fall-edge detector 202 to go high again, ending the output pulse applied to the 1T1R cell 902.

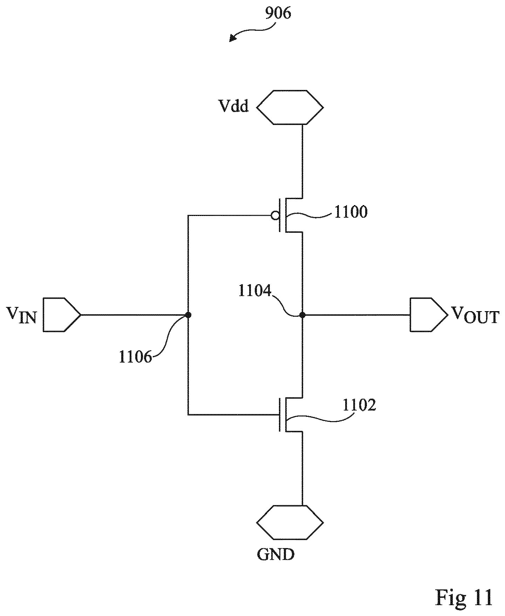

Figure 11 schematically illustrates an example of a hardware implementation of the unbalanced inverter 906 of Figure 9.

The unbalanced inverter 906 is for example a CMOS inverter comprising a PMOS transistor 1100 and an NMOS transistor 1104 coupled in series via their main conducting nodes between the supply voltage rail *V_{ref}* and ground (GND). The gates of the transistors 1100, 1102 are coupled in the input node 1106 of the inverter receiving an input voltage *V_{IN},* and an intermediate node 1104 between the transistors 1100, 1102 is coupled to an output node of the inverter 906, providing an output voltage *V_{OUI}.*

The widths of the transistors 1100, 1102 are for example different from each other, leading to the unbalanced operation. For example, the width of the NMOS transistor 1102 is lower than the width of the PMOS transistor 1104 by a factor of at least two, and for example by a facture of more than 10, or of more than 100 in some embodiments.

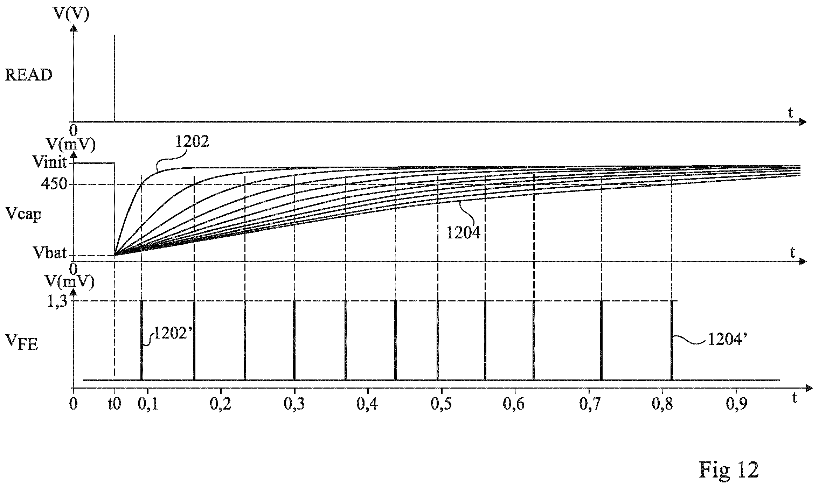

Figure 12 is temporal diagram illustrating time delays implemented by the synapse circuit 106 according to an embodiment of the present disclosure.

In particular, Figure 12 illustrates a signal READ, the voltage *V_{cap}* and the output voltage *V_{FE}* of the fall-edge detector 202. Eleven curves show the evolution of the voltage *V_{cap}* for various different values of the resistance of the resistive element 108. For example, a first curve 1202 illustrates a resistance of around 1 Mohm, and last curve 1204 illustrates a resistance of around 1 Gohm. Eleven corresponding pulses of the output voltage *V_{FE}* are illustrated, with a first pulse 1202' representing the pulse generated in response to the *V_{cap}* voltage of curve 1202, and a last pulse 1204' representing the pulse generated in response to the *V_{cap}* voltage of curve 1204.

The input signal READ, received by the synapse circuit 106, arises at a time *t*₀ and thus causes the voltages *V_{cap}* to decrease from their initial value *V_{ínít}* to a lower value *V_{bot}*. After the reception of the signal READ, the voltages *V_{cap}* begin to increase to the value *V_{ínít}* with a speed depending on the resistance of the associated resistive element 108.

When the voltages *V_{cap}* cross the threshold value *Vₜₕ*, for example equal to 450 mV, the fall-edge detector 202 asserts the output signal, which for example supplies a voltage *V_{FE}* of 1.3 mV to the gate of the transistor 116. Hence, the output current *I_{weight}* produced at the output of the synapse circuit 106 is proportional to the resistance value of the resistive element 110, and its timing is a function of the resistance value of the resistive element 108.

Although Figure 12 illustrates an example in which the capacitor 120 is initially charged by the signal READ, and then discharged via the programmable resistive element 108, in alternative embodiments, the capacitor 120 could be initially discharged by the signal READ, and then recharged via the programmable resistive element 108.

An advantage of the embodiments described herein is that it is possible to take into consideration spike arrival times in a neural network, in a simple and area-efficient manner. Furthermore, by initially programming the resistive elements 108 to a range of different resistances falling within a log distribution, and then adjusting only the synaptic weights during the training phase, the complexity of the training operation can remain relatively low.

Various embodiments and variants have been described. Those skilled in the art will understand that certain features of these embodiments can be combined and other variants will readily occur to those skilled in the art. For example, while a specific example of an implementation of the fall-edge detector 202 has been described, it will be apparent to those skilled in the art that different implementations would be possible, and that this circuit could be replaced in alternative embodiments by a comparator capable of generating an output pulse. Furthermore, while embodiments have been described in which the synaptic weights are applied using resistive memory elements, in alternative embodiments, it would be possible to use other type of memory devices to store the synaptic weights.

Finally, the practical implementation of the embodiments and variants described herein is within the capabilities of those skilled in the art based on the functional description provided hereinabove. In particular, the manner in which an artificial neural network can be trained to perform a desired function is within the capabilities of those skilled in the art. is lower than the width of the PMOS transistor 1104 by a factor of at least two, and for example by a facture of more than 10, or of more than 100 in some embodiments.

Figure 12 is temporal diagram illustrating time delays implemented by the synapse circuit 106 according to an embodiment of the present disclosure.

In particular, Figure 12 illustrates a signal READ, the voltage *V_{cap}* and the output voltage *V_{FE}* of the fall-edge detector 202. Eleven curves show the evolution of the voltage *V_{cap}* for various different values of the resistance of the resistive element 108. For example, a first curve 1202 illustrates a resistance of around 1 Mohm, and last curve 1204 illustrates a resistance of around 1 Gohm. Eleven corresponding pulses of the output voltage *V_{FE}* are illustrated, with a first pulse 1202' representing the pulse generated in response to the *V_{cap}* voltage of curve 1202, and a last pulse 1204' representing the pulse generated in response to the *V_{cap}* voltage of curve 1204.

The input signal READ, received by the synapse circuit 106, arises at a time *t*₀ and thus causes the voltages *V_{cap}* to decrease from their initial value *V_{ínít}* to a lower value *V_{bot}*. After the reception of the signal READ, the voltages *V_{cap}* begin to increase to the value *V_{ínít}* with a speed depending on the resistance of the associated resistive element 108.

When the voltages *V_{cap}* cross the threshold value *Vₜₕ*, for example equal to 450 mV, the fall-edge detector 202 asserts the output signal, which for example supplies a voltage *V_{FE}* of 1.3 mV to the gate of the transistor 116. Hence, the output current *I_{weight}* produced at the output of the synapse circuit 106 is proportional to the resistance value of the resistive element 110, and its timing is a function of the resistance value of the resistive element 108.

Although Figure 12 illustrates an example in which the capacitor 120 is initially charged by the signal READ, and then discharged via the programmable resistive element 108, in alternative embodiments, the capacitor 120 could be initially discharged by the signal READ, and then recharged via the programmable resistive element 108.

An advantage of the embodiments described herein is that it is possible to take into consideration spike arrival times in a neural network, in a simple and area-efficient manner. Furthermore, by initially programming the resistive elements 108 to a range of different resistances falling within a log distribution, and then adjusting only the synaptic weights during the training phase, the complexity of the training operation can remain relatively low.

Various embodiments and variants have been described. Those skilled in the art will understand that certain features of these embodiments can be combined and other variants will readily occur to those skilled in the art. For example, while a specific example of an implementation of the fall-edge detector 202 has been described, it will be apparent to those skilled in the art that different implementations would be possible, and that this circuit could be replaced in alternative embodiments by a comparator capable of generating an output pulse. Furthermore, while embodiments have been described in which the synaptic weights are applied using resistive memory elements, in alternative embodiments, it would be possible to use other type of memory devices to store the synaptic weights.

Finally, the practical implementation of the embodiments and variants described herein is within the capabilities of those skilled in the art based on the functional description provided hereinabove. In particular, the manner in which an artificial neural network can be trained to perform a desired function is within the capabilities of those skilled in the art.

## Claims

1. A circuit implementing a neural network comprising:
- a first synapse circuit (106) configured to apply a first time delay to a first input signal (READ1) using a first resistive memory element (108) and to generate a first output signal at an output of the first synapse circuit by applying a first weight to the delayed first input signal, the first synapse circuit (106) further comprises a first capacitor (120) coupled to the first resistive memory element (108) and configured to introduce the first time delay and a third programmable (110) resistive element storing a synaptic weight of the synapse circuit; and
- a second synapse circuit (106) configured to apply a second time delay, different to the first time delay, to the first input signal, or to a second input signal (READN), using a second resistive memory element (108) and to generate a second output signal at an output of the second synapse circuit by applying a second weight to the delayed second input signal, the second synapse circuit further comprises a second capacitor (120) coupled to the second resistive memory element (108) and configured to introduce the second time delay and a fourth programmable resistive element storing a synaptic weight of the synapse circuit;
- a dendritic circuit comprising the first and the second synapse circuits and an output line coupled to the outputs of the first and second synapse circuits, the output line being coupled to an input of a neuron circuit of the neural network, wherein the first and the second weights and the first and the second time delays are adjusted during a training phase such that when a certain temporal feature is present in the first input signal (READ1) or in the second input signal (READN) of the dendritic circuit, the first and second output signals from each synapse circuit of the dendritic circuit are aligned, causing the neuron circuit to generate an output spike when a threshold is reached.

2. The circuit of claim 1, wherein:
- the first weight is a function of the resistance of the third resistive memory element (110); and
- the second weight is a function of the resistance of the fourth resistive memory element (110).

3. The circuit according to claim 1 or 2, wherein the first and the second resistive elements (108) are programmed to have a high resistance state (HRS).

4. The circuit according to any of claims 1 to 3, wherein the third and the fourth resistive elements (110) are programmed to have a low resistance state (LRS).

5. The circuit according to any of claims 1 to 4, wherein the first and second resistive memory elements (108) are Ferro-Tunnel Junction elements.

6. The circuit according to any of claims 1 to 5, wherein the third and fourth resistive memory elements (110) are OxRAM elements.

7. The circuit according to any of claims 1 to 6, wherein:
- the first synapse circuit (106) further comprises a first comparator circuit (118) coupled to the first resistive memory element (108) and configured to generate an output pulse after the first time delay; and
- the second synapse circuit (106) further comprises a second comparator circuit (118) coupled to the second resistive memory element (108) and configured to generate an output pulse after the second time delay.

8. The circuit
according to claim 7, wherein the first and the second comparator circuits (118) are a fall-edge detector circuit (202).

9. A method comprising:
- applying, by a first synapse circuit (106), a first time delay to a first input signal (READ) using a first resistive memory element (108), the first synapse circuit (106) comprising a first capacitor (120) coupled to the first resistive memory element (108) and configured to introduce the first time delay and a third programmable resistive element (110) storing a synaptic weight of the synapse circuit;
- generating a first output signal at an output of the first synapse circuit by applying a first weight to the delayed first input signal;
- applying, by a second synapse circuit (106), a second time delay, different to the first time delay, to the first input signal, or to a second input signal, using a second resistive memory element (108), the second synapse circuit (106) comprising a second capacitor (120) coupled to the second resistive memory element (108) and configured to introduce the second time delay and a fourth programmable resistive element storing a synaptic weight of the synapse circuit,; and
- generating a second output signal at an output of the second synapse circuit by applying a second weight to the delayed second input signal,
the first and the second synapse circuits being comprised in a dendritic circuit, the dendritic circuit further comprising an output line coupled to the outputs of the first and second synapse circuits, the output line being coupled to an input of a neuron circuit of the neural network, wherein the first and the second weights and the first and the second time delays are adjusted during a training phase such that when a certain temporal feature is present in the first input signal (READ1) or in the second input signal (READN) of the dendritic circuit, the first and second output signals from each synapse circuit of the dendritic circuit are aligned, causing the neuron circuit to generate an output spike when a threshold is reached.

## Patentansprüche

1. Eine Schaltung, die ein neuronales Netzwerk implementiert, die Folgendes aufweist:
- eine erste Synapsenschaltung (106), eingerichtet zum Anwenden einer ersten Zeitverzögerung auf ein erstes Eingangssignal (READ1) unter Verwendung eines ersten resistiven Speicherelements (108) und zum Erzeugen eines ersten Ausgangssignals an einem Ausgang der ersten Synapsenschaltung durch Anwenden eines ersten Gewichts auf das verzögerte erste Eingangssignal, wobei die erste Synapsenschaltung (106) ferner einen ersten Kondensator (120) aufweist, der mit dem ersten resistiven Speicherelement (108) gekoppelt und eingerichtet zum Einführen der ersten Zeitverzögerung ist, und ein drittes programmierbares resistives Element (110), das ein synaptisches Gewicht der Synapsenschaltung speichert; und
- eine zweite Synapsenschaltung (106), eingerichtet zum Anwenden einer zweiten Zeitverzögerung, die sich von der ersten Zeitverzögerung unterscheidet, auf das erste Eingangssignal oder auf ein zweites Eingangssignal (READN) unter Verwendung eines zweiten resistiven Speicherelements (108) und zum Erzeugen eines zweiten Ausgangssignals an einem Ausgang der zweiten Synapsenschaltung durch Anwenden eines zweiten Gewichts auf das verzögerte zweite Eingangssignal, wobei die zweite Synapsenschaltung ferner einen zweiten Kondensator (120) aufweist, der mit dem zweiten resistiven Speicherelement (108) gekoppelt und eingerichtet zum Einführen der zweiten Zeitverzögerung ist, und ein viertes programmierbares resistives Element, das ein synaptisches Gewicht der Synapsenschaltung speichert;
- eine dendritische Schaltung, die die erste und die zweite Synapsenschaltung und eine Ausgangsleitung aufweist, die mit den Ausgängen der ersten und zweiten Synapsenschaltungen gekoppelt ist, wobei die Ausgangsleitung mit einem Eingang einer Neuronenschaltung des neuronalen Netzwerks gekoppelt ist, wobei das erste und das zweite Gewicht und die erste und die zweite Zeitverzögerung während einer Trainingsphase derart eingestellt werden, dass, wenn ein bestimmtes zeitliches Merkmal in dem ersten Eingangssignal (READ1) oder in dem zweiten Eingangssignal (READN) der dendritischen Schaltung vorhanden ist, das erste und das zweite Ausgangssignal von jeder Synapsenschaltung der dendritischen Schaltung ausgerichtet sind, wodurch die Neuronenschaltung veranlasst wird, einen Ausgangsspike zu erzeugen, wenn ein Schwellenwert erreicht wird.

2. Die Schaltung nach Anspruch 1, wobei:
- das erste Gewicht eine Funktion des Widerstands des dritten resistiven Speicherelements (110) ist; und
- das zweite Gewicht eine Funktion des Widerstands des vierten resistiven Speicherelements (110) ist.

3. Die Schaltung nach Anspruch 1 oder 2, wobei das erste und das zweite resistive Element (108) programmiert sind, einen Zustand mit hohem Widerstand (HRS) aufzuweisen.

4. Die Schaltung nach einem der Ansprüche 1 bis 3, wobei das dritte und das vierte resistive Element (110) programmiert sind, einen Zustand mit niedrigem Widerstand (LRS) aufzuweisen.

5. Die Schaltung nach einem der Ansprüche 1 bis 4, wobei der erste und der zweite resistive Speicher (108) Ferro-Tunnelübergangselemente sind.

6. Die Schaltung nach einem der Ansprüche 1 bis 5, wobei das dritte und das vierte resistive Speicherelement (110) OxRAM-Elemente sind.

7. Die Schaltung nach einem der Ansprüche 1 bis 6, wobei:
- die erste Synapsenschaltung (106) ferner eine erste Komparatorschaltung (118) aufweist, die mit dem ersten resistiven Speicherelement (108) gekoppelt und eingerichtet zum Erzeugen eines Ausgangsimpulses nach der ersten Zeitverzögerung ist; und
- die zweite Synapsenschaltung (106) ferner eine zweite Komparatorschaltung (118) aufweist, die mit dem zweiten resistiven Speicherelement (108) gekoppelt und eingerichtet zum Erzeugen eines Ausgangsimpulses nach der zweiten Zeitverzögerung ist.

8. Die Schaltung nach Anspruch 7, wobei die erste und die zweite Komparatorschaltung (118) eine Fallflanken-Detektorschaltung (202) sind.

9. Ein Verfahren, das Folgendes aufweist:
- Anwenden, durch eine erste Synapsenschaltung (106), einer ersten Zeitverzögerung auf ein erstes Eingangssignal (READ) unter Verwendung eines ersten resistiven Speicherelements (108), wobei die erste Synapsenschaltung (106) einen ersten Kondensator (120) aufweist, der mit dem ersten resistiven Speicherelement (108) gekoppelt und eingerichtet zum Einführen der ersten Zeitverzögerung ist, und ein drittes programmierbares resistives Element (110), das ein synaptisches Gewicht der Synapsenschaltung speichert;
- Erzeugen eines ersten Ausgangssignals an einem Ausgang der ersten Synapsenschaltung durch Anwenden eines ersten Gewichts auf das verzögerte erste Eingangssignal;
- Anwenden, durch eine zweite Synapsenschaltung (106), einer zweiten Zeitverzögerung, die sich von der ersten Zeitverzögerung unterscheidet, auf das erste Eingangssignal oder auf ein zweites Eingangssignal unter Verwendung eines zweiten resistiven Speicherelements (108), wobei die zweite Synapsenschaltung (106) einen zweiten Kondensator (120) aufweist, der mit dem zweiten resistiven Speicherelement (108) gekoppelt und eingerichtet zum Einführen der zweiten Zeitverzögerung ist, und ein viertes programmierbares resistives Element, das ein synaptisches Gewicht der Synapsenschaltung speichert; und
- Erzeugen eines zweiten Ausgangssignals an einem Ausgang der zweiten Synapsenschaltung durch Anwenden eines zweiten Gewichts auf das verzögerte zweite Eingangssignal,
wobei die erste und die zweite Synapsenschaltung in einer dendritischen Schaltung enthalten sind, wobei die dendritische Schaltung ferner eine Ausgangsleitung aufweist, die mit den Ausgängen der ersten und zweiten Synapsenschaltungen gekoppelt ist, wobei die Ausgangsleitung mit einem Eingang einer Neuronenschaltung des neuronalen Netzwerks gekoppelt ist, wobei das erste und das zweite Gewicht und die erste und die zweite Zeitverzögerung während einer Trainingsphase derart eingestellt werden, dass, wenn ein bestimmtes zeitliches Merkmal in dem ersten Eingangssignal (READ1) oder in dem zweiten Eingangssignal (READN) der dendritischen Schaltung vorhanden ist, das erste und das zweite Ausgangssignal von jeder Synapsenschaltung der dendritischen Schaltung ausgerichtet sind, wodurch die Neuronenschaltung veranlasst wird, einen Ausgangsspike zu erzeugen, wenn ein Schwellenwert erreicht wird.

## Revendications

1. Circuit mettant en œuvre un réseau neuronal comprenant :
- un premier circuit synaptique (106) configuré pour appliquer un premier retard temporel à un premier signal d'entrée (READ1) en utilisant un premier élément mémoire résistif (108) et pour générer un premier signal de sortie à une sortie du premier circuit synaptique en appliquant un premier poids au premier signal d'entrée retardé, le premier circuit synaptique (106) comprenant en outre un premier condensateur (120) relié au premier élément mémoire résistif (108) et configuré pour introduire le premier retard temporel et un troisième élément mémoire résistif programmable (110) qui stocke un poids synaptique du circuit synaptique ; et
- un deuxième circuit synaptique (106) configuré pour appliquer un deuxième retard temporel, différent du premier retard temporel, au premier signal d'entrée, ou à un deuxième signal d'entrée (READN), en utilisant un deuxième élément mémoire résistif (108) et pour générer un deuxième signal de sortie à une sortie du deuxième circuit synaptique en appliquant un deuxième poids au deuxième signal d'entrée retardé, le deuxième circuit synaptique comprend en outre un deuxième condensateur (120) relié au deuxième élément mémoire résistif (108) et configuré pour introduire le deuxième retard temporel et un quatrième élément mémoire résistif programmable qui stocke un poids synaptique du circuit synaptique ;
- un circuit dendritique comprenant le premier et le deuxième circuit synaptique et une ligne de sortie reliée aux sorties des premier et deuxième circuits synaptiques, la ligne de sortie étant reliée à une entrée d'un circuit neuronal du réseau neuronal, dans lequel les premier et deuxième poids et les premier et deuxième retards temporels sont réglés pendant une phase d'apprentissage de sorte que, lorsqu'une caractéristique temporelle donnée est présente dans le premier signal d'entrée (READ1) ou dans le deuxième signal d'entrée (READN) du circuit dendritique, les premier et deuxième signaux de sortie provenant de chaque circuit synaptique du circuit dendritique soient alignés, ce qui amène le circuit neuronal à générer une impulsion de sortie lorsqu'un seuil est atteint.

2. Circuit selon la revendication 1, dans lequel :
- le premier poids est fonction de la résistance du troisième élément mémoire résistif (110) ; et
- le deuxième poids est fonction de la résistance du quatrième élément mémoire résistif (110).

3. Circuit selon la revendication 1 ou 2, dans lequel les premier et deuxième éléments résistifs (108) sont programmés pour avoir un état de haute résistance (HRS).

4. Circuit selon l'une quelconque des revendications 1 à 3, dans lequel les troisième et quatrième éléments résistifs (110) sont programmés pour avoir un état de faible résistance (LRS).

5. Circuit selon l'une quelconque des revendications 1 à 4, dans lequel les premier et deuxième éléments mémoire résistifs (108) sont des éléments à jonction tunnel ferroélectrique.

6. Circuit selon l'une quelconque des revendications 1 à 5, dans lequel les troisième et quatrième éléments mémoire résistifs (110) sont des éléments OxRAM.

7. Circuit selon l'une quelconque des revendications 1 à 6, dans lequel :
- le premier circuit synaptique (106) comprend en outre un premier circuit comparateur (118) relié au premier élément mémoire résistif (108) et configuré pour générer une impulsion de sortie après le premier retard temporel ; et
- le deuxième circuit synaptique (106) comprend en outre un deuxième circuit comparateur (118) relié au deuxième élément mémoire résistif (108) et configuré pour générer une impulsion de sortie après le deuxième retard temporel.

8. Circuit selon la revendication 7, dans lequel les premier et deuxième circuits comparateurs (118) sont des circuits détecteur de front descendant (202).

9. Procédé comprenant :
- l'application, par un premier circuit synaptique (106), d'un premier retard temporel à un premier signal d'entrée (READ) en utilisant un premier élément mémoire résistif (108), le premier circuit synaptique (106) comprenant un premier condensateur (120) relié au premier élément mémoire résistif (108) et configuré pour introduire le premier retard temporel et un troisième élément mémoire résistif programmable (110) qui stocke un poids synaptique du circuit synaptique ;
- la génération d'un premier signal de sortie à la sortie du premier circuit synaptique en appliquant un premier poids au premier signal d'entrée retardé ;
- l'application, par un deuxième circuit synaptique (106), d'un deuxième retard temporel, différent du premier retard temporel, au premier signal d'entrée, ou à un deuxième signal d'entrée, en utilisant un deuxième élément mémoire résistif (108), le deuxième circuit synaptique (106) comprenant un deuxième condensateur (120) relié au deuxième élément mémoire résistif (108) et configuré pour introduire le deuxième retard temporel et un quatrième élément mémoire résistif programmable qui stocke un poids synaptique du circuit synaptique ; et
- la génération d'un deuxième signal de sortie à la sortie du deuxième circuit synaptique en appliquant un deuxième poids au deuxième signal d'entrée retardé,
les premier et deuxième circuits synaptiques étant compris dans un circuit dendritique, le circuit dendritique comprenant en outre une ligne de sortie reliée aux sorties des premier et deuxième circuits synaptiques, la ligne de sortie étant reliée à une entrée d'un circuit neuronal du réseau neuronal, dans lequel les premier et deuxième poids ainsi que les premier et deuxième retards temporels sont réglés pendant une phase d'apprentissage de sorte que, lorsqu'une caractéristique temporelle donnée est présente dans le premier signal d'entrée (READ1) ou dans le deuxième signal d'entrée (READN) du circuit dendritique, les premier et deuxième signaux de sortie de chaque circuit synaptique du circuit dendritique soient alignés, ce qui amène le circuit neuronal à générer une impulsion de sortie lorsqu'un seuil est atteint.
